# EUROPEAN PATENT SPECIFICATION

(11) **EP 1 357 160 B1**
(45) Date of publication and mention of the grant of the patent: **08.03.2006**
(21) Application number: 03252058.7
(22) Date of filing: 01.04.2003
(51) Int. Cl.: C09D 183/14, C08F 290/14, C08G 77/04, C09D 163/00

(54) **Photo-curable coating composition for hard protective coat and coated article**
Photohärtbare Beschichtungszusammensetzung für harte Schutzschicht und beschichteter Gegenstand
Composition de revêtement photodurcissable permettant de former une couche protectrice dure et objet revêtu

(30) Priority: 01.04.2002 JP 2002098694; 01.04.2002 JP 2002098705; 01.04.2002 JP 2002098734
(43) Date of publication of application: 29.10.2003
(73) Proprietor: Shin-Etsu Chemical Co., Ltd., Chiyoda-ku Tokyo 100 (JP)
(72) Inventor: Yoshikawa, Yuji, c/oSilicone-Electronics Materials, Matsuida.machi, Usui-gun, Gunma-ken (JP); Yamaya, Masaaki, c/oSilicone-Electronics Materials, Matsuida.machi, Usui-gun, Gunma-ken (JP)
(74) Representative: Watson, Robert James

(56) References cited:
- EP-A- 0 389 927
- US-A- 4 279 717

## Description

This invention relates to photo-curable coating compositions for forming hard protective coats and articles having hard protective coats formed thereon.

### BACKGROUND

Photo-curable silicone coating compositions are coated and cured to substrates while the curing completes within a short time, requires only light exposure and eliminates a need for heating. They are advantageously applicable to those substrates which are vulnerable to thermal energy. Because of these advantages, silicone coating compositions of the photo-cure type have been developed for application in a variety of fields.

Photo-curable, especially UV-curable silicone compositions are generally divided into three cure types.
(1) UV curing of acrylic functional silicone in the presence of radical cleavage type photo-catalyst
(2) UV curing between Si-Vi and S-H groups in the presence of radical cleavage type photo-catalyst (Vi is vinyl)
(3) UV curing of epoxy functional silicone in the presence of cation release catalyst

Silicone compositions of type (1) are fast curable, but their reaction must be performed in an inert gas atmosphere because of cure inhibition by oxygen. Disadvantageously the curing apparatus must be elaborately tailored and the use of inert gas leads to an increased running cost.

Silicone compositions of type (2) are effectively curable due to minimized cure inhibition by oxygen. Because of mercapto groups involved, a disgusting odor affects the worker. They also have deficiencies including instability and a short self life.

Silicone compositions of type (3) have many advantages including UV curing, no cure inhibition by oxygen, no disgusting odor, and good adherence to substrates. Their drawback is that cure is inhibited by moisture in the atmosphere.

To overcome the drawback of type (3) compositions, an attempt has been made to add a radical polymerizable compound and a photo-radical initiator to the composition for carrying out cationic polymerization and radical polymerization at the same time.

On the other hand, cationic polymerization systems having silicone compounds introduced therein are known. For example, JP-A 56-38350 discloses a W-curable composition comprising a siloxane compound having an epoxy group and a bisaryl iodonium salt; JP-A 58-213024 discloses UV curing of a siloxane compound having an epoxy group, a siloxane compound having an acrylic group or a siloxane compound having both such functional groups; JP-A 11-104166 discloses a mold release film comprising an epoxy-modified silicone and a cationic photo-polymerization initiator; JP-B 6-89109 and JP-A 7-156267 disclose a composition comprising an alicyclic epoxy-functional siloxane, an organic alicyclic polyepoxide, and a cationic photo-polymerization initiator; and JP-A 8-269293 discloses a composition comprising an alicyclic epoxy group-containing silicone graft polymer and an onium salt photo-curing catalyst. The epoxy group-containing siloxane compounds used in these compositions are linear dimethylpolysiloxanes in which some functional groups are replaced by epoxy groups, with a focus placed on mold release properties. All these coating compositions form soft coats.

Also, JP-A 2001-158851 discloses a composition comprising an epoxy group-containing siloxane compound having a molecular weight of 500 to 500,000 and a cationic photo-polymerization initiator. The siloxane compound used therein results from hydrolytic condensation of an alkoxysilane and is difficult to control to a low molecular weight. All the siloxane compounds synthesized in Examples have a molecular weight of more than 2,500. It is difficult to form high hardness coats from such siloxane compounds.

JP-A 9-143248 discloses a composition comprising an epoxy compound, a polyorganosiloxane having alicyclic epoxy groups, and a cationic photo-polymerization initiator. Cyclic siloxane compounds having alicyclic epoxy groups are exemplary of the epoxy compound, and the organosiloxane is a linear dimethylpolysiloxane terminated with epoxy groups. This composition is expected to exert the same effect as the previous one.

JP-A 2001-40066 discloses a composition comprising an alicyclic epoxy group-containing silicone graft polymer, a polyorganosiloxane having alicyclic epoxy groups, and a cationic photo-polymerization initiator. Exemplary of the polyorganosiloxane having alicyclic epoxy groups are cyclic siloxane compounds having alicyclic epoxy groups and cyclic siloxane compounds having a plurality of alicyclic epoxy groups on side chains. No reference is made to expansion upon curing.

JP-A 2001-187812 discloses that oxide particles modified with radical polymerizable unsaturated groups and epoxy groups are effective for improving curling properties. However, this merely intends to suppress the cure shrinkage of a radical cure system, based on the fact that cationic cure systems are generally free from cure shrinkage as compared with radical cure systems.

### SUMMARY OF THE INVENTION

An object of the invention is to provide a photo-curable coating composition comprising a silicone compound having specific alicyclic epoxy groups, which is expandable upon curing and effective for forming a hard protective coat, and an article having the hard protective coat formed thereon.

Another object of the invention is to provide a photo-curable coating composition for forming a hard protective coat which experiences little or no curling, and an article having the hard protective coat formed thereon.

It has been found that when a composition comprising a specific alicyclic epoxy group-modified silicone having a relatively low molecular weight and containing many epoxy groups and a photoacid generator soluble therein is applied to form a coating, the coating cures with radiation and expands upon curing.

It has also been found that the addition of inorganic oxide fine particles to the composition enables to form a high hardness coat substantially free of curling. More particularly, a photo-curable coating composition loaded with inorganic oxide fine particles is able to form a coat substantially free of curling by virtue of cure expansion due to alicyclic epoxy groups combined with cure shrinkage due to inorganic oxide fine particles, and the coat has a high hardness on account of the inorganic oxide fine particles included.

It has further been found that when a curable resin which is shrinkable upon curing is compounded in the composition, the composition becomes little shrinkable upon curing or rather expandable upon curing. More particularly, by compounding a curable resin of radical or condensation cure system which is shrinkable upon curing, a coat which is substantially free of curling or cure shrinkage can be formed.

With respect to the cure expansion mechanism, it is presumed that epoxy groups undergo reaction with the aid of the acid generated upon exposure to light whereupon the epoxy groups undergo ring opening and crosslinking to a high crosslink density to induce cure strain, while siloxane bonds are hydrolyzed with air-borne moisture so that cleavage and rearrangement of siloxane occur to offset the strain and induce expansion. It is confirmed in fact that cure expansion is unlikely to occur in a moisture-free system. Cure expansion as contemplated herein occurs in the presence of slight moisture commonly existing in the ambient air.

According to the present invention, there is provided a photo-curable coating composition for forming a hard protective coat, comprising (A) 100 parts by weight of a silicone compound having at least three epoxycyclohexyl-bearing organic groups each directly attached to a silicon atom in a molecule, but free of alkoxy groups, and having a molecular weight of 500 to 2,100 and an epoxycyclohexyl-bearing organic group equivalent, as expressed by the weight per mole of epoxycyclohexyl-bearing organic groups, of 180 to 230, and (B) 0.1 to 5 parts by weight of a photoacid generator which is dissolvable in component (A). In preferred embodiments, the coating composition further includes (C) 30 to 400 parts by weight of inorganic oxide particles having an average particle size of 1 to 500 nm, and/or (D) 1 to 400 parts by weight of a curable resin which is shrinkable upon curing.

In the embodiment wherein component (C) is added, component (C) is incorporated into the crosslinked structure of component (A) so that the resulting coat becomes highly transparent, uniform and very hard.

The present invention also provides an article on which a hard protective coat is formed by applying and curing the coating composition.

### DESCRIPTION OF THE PREFERRED EMBODIMENTS

Component (A) in the photo-curable coating composition of the invention for forming a hard protective coat is a silicone compound which contains at least three epoxycyclohexyl-bearing organic groups each directly attached to a silicon atom in a molecule, but is free of alkoxy groups, and has a molecular weight of 500 to 2,100 and an epoxycyclohexyl-bearing organic group equivalent, as expressed by the weight per mole of epoxycyclohexyl-bearing organic groups, in the range of 180 to 230.

By mixing the above silicone compound with a photoacid generator (B) to be described later and irradiating radiation to the mixture for curing, a coat which is expandable upon curing is obtained.

The silicone compound (A) has at least three epoxycyclohexyl-bearing organic groups each directly attached to a silicon atom per molecule, and preferably 4 to 8 epoxycyclohexyl-bearing organic groups per molecule. A silicone compound having less than three epoxycyclohexyl-bearing organic groups fails to form a high hardness coat.

The silicone compound (A) has a molecular weight of 500 to 2,100, and preferably 700 to 1,900. A molecular weight of less than 500 is unlikely to induce cure strain. A silicone compound with a molecular weight of more than 2,100 and an epoxycyclohexyl equivalent of 180 to 230 is difficult to synthesize and thus undesirable from the industrial standpoint. The equivalent of epoxycyclohexyl-bearing organic groups, as expressed by the weight per mole of epoxycyclohexyl-bearing organic groups, is in the range of 180 to 230, and preferably 184 to 225. A silicone compound with an epoxycyclohexyl equivalent of less than 180 is difficult to synthesize in an industrial manner when the silicone compound consists of -R¹RSiO_{2/2}- units. A silicone compound with an epoxycyclohexyl equivalent of more than 230 has a lower R¹ content and thus undergoes less cure expansion, failing to provide a high hardness.

Additionally from the standpoint of prohibiting cure shrinkage through alcohol-removal reaction, the silicone compound (A) should be free of alkoxy groups.

From the standpoint of cure expansion, preferred component (A) is a silicone compound comprising units of the general formula (1) :

-R¹RSiO_{2/2}- (1)

which may be expressed as -R¹RSiO- wherein R is hydrogen or a monovalent hydrocarbon group and R¹ is an epoxycyclohexyl-bearing organic group. This silicone compound contains at least three R¹ in a molecule, but is free of alkoxy groups, and has a molecular weight of 500 to 2,100 and an R¹ equivalent of 180 to 220, as expressed by the weight per mole of R¹.

Also preferably, the silicone compound (A) has a linear or cyclic structure which is prone to cure expansion. Because of considerable cure expansion, the preferred silicone compound of linear structure is a linear silicone compound having the general formula (2): 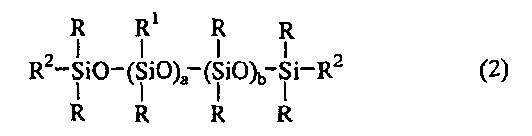
wherein R and R¹ are as defined above, R² is R or R¹, and a is an integer of 1 to 10, with the proviso that R² at each end is R¹ when a = 1, and at least one of R² is R¹ when a = 2, b is an integer of 0 to 8, the sum of a+b is 2 to 10, and each R, R¹ and R² may be the same or different,
more preferably, a linear silicone compound having the general formula (2') : 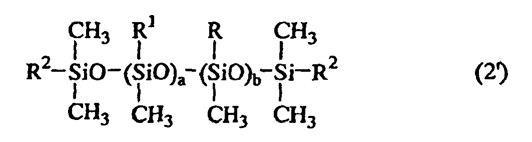
wherein R¹, R², a and b are as defined above,
most preferably, a linear silicone compound having the general formula (3):

(CH₃)₃SiO(R¹CH₃SiO)ₘSi(CH₃)₃ (3)

wherein R¹ is as defined above and m is an integer of 3 to 10, especially 4 to 8.

The preferred silicone compound of cyclic structure is a cyclic silicone compound having the general formula (4): 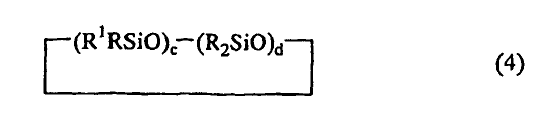
wherein R and R¹ are as defined above, c is an integer of 3 to 5, especially 3 or 4, d is an integer of 0 to 3, especially 0 or 1, and the sum of c+d is 3 to 5, especially 4,
more preferably, a cyclic silicone compound having the general formula (4'): 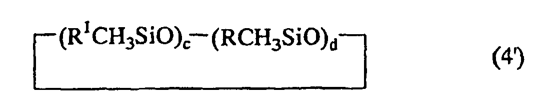
wherein R, R¹, c and d are as defined above,
most preferably, a cyclic silicone compound having the general formula (5): 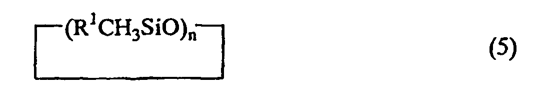
wherein R¹ is as defined above and n is an integer of 3 to 5, especially 4.

In the foregoing formulae, R¹ is an epoxycyclohexyl-bearing organic group, for example, a 3,4-epoxycyclohexylalkyl group such as 3,4-epoxycyclohexylethyl. R is hydrogen or a substituted or unsubstituted monovalent hydrocarbon group, preferably of 1 to 20 carbon atoms, more preferably 1 to 8 carbon atoms. Examples include hydrogen, alkyl groups such as methyl, ethyl, propyl, butyl, hexyl, and octyl; aryl groups such as phenyl and tolyl; alkenyl groups such as vinyl and allyl, and substituted ones of the foregoing groups in which some or all of the hydrogen atoms are replaced by glycidyl (exclusive of epoxycyclohexyl), methacryl, acryl, mercapto, amino or other groups. Of these, methyl, ethyl and hydrogen are preferred, with methyl being most preferred.

The silicone compound (A) can be prepared by addition reaction or hydrosilylation of an organohydrogenpolysiloxane with 4-vinylcyclohexene oxide in the presence of a catalyst such as a platinum compound.

Illustrative examples of suitable silicone compounds are given below.

(R^{e}(CH₃)₂SiO)₃CH₃Si,

(R^{e}(CH₃)₂SiO)₄Si,

(CH₃)₃SiO(R¹CH₃SiO)₄Si(CH₃)₃,

(CH₃)₃SiO(R¹CH₃SiO)₅Si(CH₃)₃,

(CH₃)₃SiO(R¹CH₃SiO)₆Si(CH₃)₃,

(CH₃)₃SiO(R¹CH₃SiO)₇Si(CH₃)₃,

(CH₃)₃SiO(R¹CH₃SiO)₈Si(CH₃)₃,

(CH₃)₃SiO(R¹CH₃SiO)₉Si(CH₃)₃,

(CH₃)₃SiO(R¹CH₃SiO)₁₀Si(CH₃)₃,

R¹(CH₃)₂SiO(R¹CH₃SiO)Si(CH₃)₂R¹,

R¹(CH₃)₂SiO(R¹CH₃SiO)₂Si(CH₃)₂R¹,

R¹(CH₃)₂SiO(R¹CH₃SiO)₃Si(CH₃)₂R¹,

R¹(CH₃)₂SiO(R¹CH₃SiO)₄Si(CH₃)₂R¹,

R¹(CH₃)₂SiO(R¹CH₃SiO)₅Si(CH₃)₂R¹,

R¹(CH₃)₂SiO(R¹CH₃SiO)₆Si(CH)₂R¹,

R¹(CH₃)₂SiO(R¹CH₃SiO)₇Si(CH₃)₂R¹,

R¹(CH₃)₂SiO(R¹CH₃SiO)₈Si(CH₃)₂R¹,

R¹(CH₃)₂SiO(R¹CH₃SiO)₉Si(CH₃)₂R¹,

R¹(CH₃)₂SiO(R¹CH₃SiO)₂((CH₃)₂SiO)₂Si(CH₃)₂R¹,

R¹(CH₃)₂SiO(R¹CH₃SiO)₃((CH₃)₂SiO)Si(CH₃)₂R¹,

R¹(CH₃)₂SiO(R¹CH₃SiO)₃((CH₃)₂SiO)₂Si(CH₃)₂R¹,

R¹(CH₃)₂SiO(R¹CH₃SiO)₄((CH₃)₂SiO)Si(CH₃)₂R¹,

R¹(CH₃)₂SiO(R¹CH₃SiO)₄((CH₃)₂SiO)₂Si(CH₃)₂R¹,

R¹(CH₃)₂SiO(R¹CH₃SiO)₅((CH₃)₂SiO)Si(CH₃)₂R¹,

R¹(CH₃)₂SiO(R¹CH₃SiO)₅((CH₃)₂SiO)₂Si(CH₃)₂R¹,

R¹(CH₃)₂SiO(R¹CH₃SiO)₅((CH₃)₃SiO)₃Si(CH₃)₂R¹.

R¹(CH₃)₂SiO(R¹CH₃SiO)₆((CH₃)₂SiO)Si(CH₃)₂R¹,

R¹(CH₃)₂SiO(R¹CH₃SiO)₆((CH₃)₂SiO)₂Si(CH₃)₂R¹,

R¹(CH₃)₂SiO(R¹CH₃SiO)₆((CH₃)₂SiO)₃Si(CH₃)₂R¹,

R¹(CH₃)₂SiO(R¹CH₃SiO)₇((CH₃)₂SiO)Si(CH₃)₂R¹,

R¹(CH₃)₂SiO(R¹CH₃SiO)₇((CH₃)₂SiO)Si(CH₃)₂R¹,

R¹(CH₃)₂SiO(R¹CH₃SiO)₇((CH₃)₂SiO)Si(CH₃)₂R¹,

R¹(CH₃)₂SiO(R¹CH₃SiO)₇((CH₃)₂SiO)₄Si(CH₃)₂R¹,

R¹(CH₃)₂SiO(R¹CH₃SiO)₈((CH₃)₂SiO)Si(CH₃)₂R¹,

R¹(CH₃)₂SiO(R¹CH₃SiO)₈((CH₃)₂SiO)₂Si(CH₃)₂R¹,

R¹(CH₃)₂SiO(R¹CH₃SiO)₈((CH₃)₂SiO)₃Si(CH₃)₂R¹,

R¹(CH₃)₂SiO(R¹CH₃SiO)₄(R⁶CH₃SiO)Si(CH₃)₂R¹,

R¹(CH₃)₂SiO(R¹CH₃SiO)₅(R⁶CH₃SiO)Si(CH₃)₂R¹,

R¹(CH₃)₂SiO(R¹CH₃SiO)₆(R⁶CH₃SiO)Si(CH₃)₂R¹,

R¹(CH₃)₂SiO(R¹CH₃SiO)₇(R⁶CH₃SiO)Si(CH₃)₂R¹,

R¹(CH₃)₂SiO(R¹CH₃SiO)₈(R⁶CH₃SiO)Si(CH₃)₂R¹,

R¹(CH₃)₂SiO(R¹CH₃SiO)₉(R⁶CH₃SiO)Si(CH₃)₂R¹,

(R¹CH₃SiO)₃,

(R¹CH₃SiO)₄,

(R²CH₃SiO)₅,

(R¹CH₃SiO)₃((CH₃)₂SiO).

(R¹CH₃SiO)₃(C₃H₇(CH₃)SiO)

Herein, R¹ is as defined above and R⁶ is methacryloxypropyl.

Alternatively, the silicone compound (A) can be a co-hydrolyzate between an alkoxysilane having an epoxycyclohexyl group such as R¹Si(OCH₃)₃ or R¹CH₃Si(OCH₃)₂ and another alkoxysilane.

Component (B) is a photoacid generator which is dissolvable in component (A). Any desired initiator may be used as the photoacid generator as long as it has an ability to open an epoxy ring under the action of light. Preferred photoacid generators are onium salt photo-initiators, typically diaryliodonium salts, triarylsulfonium salts, monoaryldialkyl sulfonium salts, triarylselenonium salts, tetraarylphosphonium salts and aryldiazonium salts represented by the following general formulae.

R⁷₂I⁺X⁻

R⁷₃ S⁺X⁻

R⁷₂R⁸S⁺X⁻

R⁷R⁸₂S⁺X⁻

R⁷₃Se⁺X⁻

R⁷₄P⁺X⁻

R⁷N₂⁺X⁻

Herein, R⁷ is a C₆₋₃₀ aryl group, R⁸ is a C₁₋₃₀ alkyl group, and X⁻ is an anion such as SbF₆⁻, AsF₆⁻, PF₆⁻, BF₄⁻, HSO₄⁻, ClO₄⁻, Cl⁻ or CF₃SO₃⁻.

Salts of the following general formula (6) are preferred for solubility in component (A).

R⁴₂I⁺X⁻ (6)

wherein R⁴ is -C₆H₄-R⁵ wherein R⁵ is an alkyl group having at least 6 carbon atoms, preferably 6 to 24 carbon atoms, more preferably 6 to 18 carbon atoms, and X⁻ is SbF₆⁻, AsF₆⁻, PF₆⁻, BF₄⁻, HSO₄⁻, ClO₄⁻, Cl⁻ or CF₃SO₃⁻.

Suitable alkyl groups of at least 6 carbon atoms represented by R⁵ include C₆H₁₃, C₇H₁₅, C₈H₁₇, C₉H₁₉, C₁₀H₂₁, C₁₁H₂₃, C₁₂H₂₅, C₁₃H₂₇, C₁₄H₂₉, C₁₅H₃₁, C₁₆H₃₃, C₁₇H₃₅ and C₁₈H₃₇, with C₁₂H₂₅ being especially preferred.

The photoacid generator (B) is added in an amount of 0.1 to 5 parts by weight per 100 parts by weight of component (A). Less than 0.1 part of component (B) results in under-uring and no cure expansion. More than 5 parts of component (B) achieves no further effects and gives rise to an economical problem.

In one preferred embodiment of the invention, the composition further includes (C) inorganic oxide particles having an average particle size of 1 to 500 nm. The nano-particulate inorganic oxide (C) is added not only for the purpose of improving the hardness of the coat, but also for the purposes of imparting such functions as a high or low refractive index, electric conductivity and anti-reflection to the coat.

Preferred inorganic oxide used in the form of particles is an oxide of at least one element selected from the group consisting of silicon, aluminum, zirconium, titanium, zinc, germanium, indium, tin, antimony and cerium. Suitable oxides include silica, aluminum oxide (alumina), zirconium oxide (zirconia), titanium oxide (titania), zinc oxide, germanium oxide, indium oxide, tin oxide, indium tin oxide (ITO), antimony oxide, cerium oxide and compound oxides thereof. Of these, silica, alumina, zirconia, titania and antimony oxide are preferred for high hardness. These oxides may be used alone or in admixture.

The inorganic oxide particles are preferably in the form of a powder or a solvent-dispersed sol. In the latter case, for compatibility with other components and dispersibility, the dispersing medium is preferably an organic solvent. Suitable solvents include alcohols such as methanol, ethanol, isopropanol, butanol, and octanol; ketones such as acetone, methyl ethyl ketone, methyl isobutyl ketone, and cyclohexanone; esters such as ethyl acetate, butyl acetate, ethyl lactate, γ-butyrolactone, propylene glycol monomethyl ether acetate, and propylene glycol monoethyl ether acetate; ethers such as ethylene glycol monomethyl ether and diethylene glycol monobutyl ether; aromatic hydrocarbons such as benzene, toluene, and xylene; and amides such as dimethylformamide, dimethylacetamide and N-methylpyrrolidone. Of these, methanol, isopropanol, butanol, methyl ethyl ketone and methyl isobutyl ketone are preferred, with methyl ethyl ketone being most preferred.

The inorganic oxide particles (C) should have an average particle size of 1 to 500 nm, preferably 5 to 200 nm, more preferably 10 to 100 nm. With an average particle size of more than 500 nm, the cured part has low transparency or the coat has a poor surface state.

Commercial products may be used as the inorganic oxide particles (C). Many products of silicon oxide particles (e.g., silica particles) are marketed. Colloidal silica is commercially available under the trade name of Methanol Silica Sol, IPA-ST, MEK-ST, NBA-ST, XBA-ST, DMAC-ST, ST-UP, ST-OUP, ST-20, ST-40, ST-C, ST-N, ST-O, ST-50, and ST-OL from Nissan Chemical Co., Ltd. Powder silica is commercially available under the trade name of Aerosil 130, Aerosil 300, Aerosil 380, Aerosil TT600 and Aerosil OX50 from Nippon Aerosil Co., Ltd.; Sildex H31, H32, H51, H52, H121 and H122 from Asahi Glass Co., Ltd.; E220A and E220 from Nippon Silica Industry Co., Ltd.; SYLYSIA 470 from Fuji Sylysia Co., Ltd.; and SGG flake from Nippon Sheet Glass Co., Ltd.

Alumina is available as water dispersion under the trade name of Alumina Sol-100, -200, and -520 from Nissan Chemical Co., Ltd., as isopropanol dispersion under the trade name of AS-150I from Sumitomo Osaka Cement Co., Ltd., as toluene dispersion under the trade name of AS-150T from Sumitomo Osaka Cement Co., Ltd. Zirconia is available as toluene dispersion under the trade name of HXU-110JC from Sumitomo Osaka Cement Co., Ltd. Water dispersion of zinc antimonate powder is available under the trade name of Celnacs from Nissan Chemical Co., Ltd. Powders and solvent dispersions of alumina, titanium oxide, tin oxide, indium oxide and zinc oxide include Nano Tek from C.I. Kasei Co., Ltd. Water dispersed sol of antimony-doped tin oxide is available under the trade name of SN-100D from Ishihara Sangyo Kaisha, Ltd. ITO powder is available from Mitsubishi Material Co., Ltd. Water dispersion of cerium oxide is available under the trade name of Needral from Taki Chemical Co., Ltd.

The inorganic oxide particles may take the form of spherical, hollow (having a cavity within the particle), porous, rod-shape, plate-shape, fibrous, or irregular shape, and preferably spherical or hollow shape. In particular, a coat loaded with hollow particles has a high hardness and a low refractive index so that it is applicable as an antireflection film. Also, the inorganic oxide particles may be modified with epoxy or (meth)acrylic groups.

An appropriate amount of inorganic oxide particles (C) used is 30 to 400 parts, especially 50 to 150 parts by weight per 100 parts by weight of component (A). Less than 30 parts of particles may lead to insufficient hardness and cure expansion whereas more than 400 parts may give rise to such problems as crack generation.

In a further preferred embodiment of the invention, the composition further includes (D) a curable resin which is shrinkable upon curing. In general, when the silicone compound (A) is cured with component (B), cure expansion occurs. By combining the silicone compound (A) with the curable resin (D) having cure shrinkage capability, a cured coat free of curling is obtainable.

The curable resins (D) having cure shrinkage capability include radical cure resins and condensation cure resins. Acrylic resins are preferred radical cure resins, and silicone resins are preferred condensation cure resins.

Radical cure acrylic resins are obtained by polymerizing polyfunctional (meth)acrylates with radical initiators. Suitable polyfunctional (meth)acrylates include trimethylolpropane tri(meth)acrylate, ditrimethylolpropane tetra(meth)acrylate, pentaerythritol tri(meth)acrylate, pentaerythritol tetra(meth)acrylate, dipentaerythritol penta(meth)acrylate, dipentaerythritol hexa(meth)acrylate, glycerin tri(meth)acrylate, trimethylol propane EO-added tri(meth)acrylate, glycerin PO-added tri(meth)acrylate, tris(meth)acryloyloxyethyl phosphate, tris(2-hydroxyethyl)isocyanurate tri(meth)acrylate, ethylene glycol di(meth)acrylate, 1,3-butanediol di(meth)acrylate, 1,4-butanediol di(meth)acrylate, 1,6-hexanediol di(meth)acrylate, 1,9-nonanediol di(meth)acrylate, 2-n-butyl-2-ethyl-1,3-propanediol diacrylate, neopentyl glycol di(meth)acrylate, diethylene glycol di(meth)acrylate, triethylene glycol di(meth)acrylate, tetraethylene glycol di(meth)acrylate, dipropylene glycol di(meth)acrylate, tripropylene glycol di(meth)acrylate, bis(2-hydroxyethylisocyanurate di(meth)acrylate, and bisphenol A EO-added di(meth)acrylate.

There may be contained silica sol treated with an alkoxysilane having a polymerizable functional group such as γ-methacryloxypropyltrimethoxysilane. Also useful are cyclic silicones having (meth)acryloxypropyl groups represented by the following general formulae (7) to (9):

(R⁷CH₃SiO)₃ (7),

(R⁷CH₃SiO)₄ (8),

and

(R⁷CH₃SiO)₅ (9),

and chain-like silicones having the general formula (10):

(CH₃)₃SiO(R⁷CH₃SiO)ₓ((CH₃)₂SiO)_{y}Si(CH₃)₃ (10)

wherein R⁷ is (meth)acryloxypropyl, x is an integer of 3 to 100, and y is an integer of 0 to 100.

Suitable radical initiators include 1-hydroxycyclohexylphenyl ketone, 2-benzyl-2-dimethylamino-1-(4-morpholinophenyl)-butanone-1, 2,2-dimethoxy-1,2-diphenylethan-1-one, benzophenone, 2-methyl-1-(4-(methylthio)phenyl)-2-morphornopropanone-1, bis(cyclopentadienyl)-bis(2,6-difluoro-3-(pyr-1-yl)titanium, 1-(4-(2-hydroxyethoxy)phenyl)-2-hydroxy-2-methyl-1-propan-1-one, and 2-hydroxy-2-methyl-1-phenylpropan-1-one.

The condensation curable silicone resins include silicone resins having silanol or alkoxy groups. Reaction products of such silicone resins with organic resins such as epoxy resins, acrylic resins and polyester are also useful.

Suitable silicone resins are obtained through partial or complete hydrolysis of alkylalkoxysilanes (e.g., tetramethoxysilane, tetraethoxysilane, methyltrimethoxysilane, methyltriethoxysilane, propyltrimethoxysilane, hexyltrimethoxysilane, phenyltrimethoxysilane, dimethyldimethoxysilane, dimethyldiethoxysilane, diphenyldimethoxysilane, diphenyldiethoxysilane, and trimethylmethoxysilane), chlorosilanes (e.g., tetrachlorosilane, ethyltrichlorosilane, propyltrichlorosilane, hexyltrichlorosilane, phenyltrichlorosilane, dimethyldichlorosilane, diethyldichlorosilane, diphenyldichlorosilane, and trimethylchlorosilane), or alkoxysilanes having an epoxycyclohexyl, glycidoxy, methacryloxy, amino or mercapto group. Since the resulting silicone resins contain silanol or alkoxy groups, they release water or alcohol and incur volume shrinkage upon curing.

The amount of the curable resin (D) added is 1 to 400 parts, preferably 5 to 200 parts, more preferably 10 to 100 parts by weight per 100 parts by weight of component (A). The amount of the curable resin added is determined as appropriate in accordance with the degree of cure expansion of component (A) so that the resulting coat may be free of curling. Less than 1 part of component (D) provides little cure shrinkage effects, resulting in a curled coat. More than 400 parts of component (D) provides excessive cure shrinkage effects, also resulting in a curled coat.

In the hard protective coat-forming photo-curable coating composition of the invention comprising components (A) and (B) and optionally, components (C) and (D), additives commonly used in coating compositions such as organic solvents, organic or inorganic pigments, body pigments, antifoaming agents, leveling agents, and lubricants may be compounded as long as they do not compromise the objects of the invention.

The hard protective coat-forming photo-curable coating composition of the invention can be applied to the surface of plastic films of polycarbonate, polyethylene terephthalate, acrylic resin, TAC and the like, by conventional coating techniques such as roll coating, gravure coating, gravure offset coating, curtain flow coating, reverse coating, screen printing, spraying and dipping. The thickness of cured coat varies with different applications, and is preferably in the range of about 0.5 to 500 µm, more preferably about 5 to 50 µm.

The light source used for emitting radiation for curing is generally selected from light sources of emitting light with a wavelength in the range of 200 to 450 nm, for example, high-pressure mercury lamps, ultrahigh-pressure mercury lamps, xenon lamps, and carbon arc lamps. The exposure or radiation dose is preferably about 10 to 5,000 mJ/cm², especially about 20 to 1,000 mJ/cm², though not critical. The curing time is usually about 0.5 second to 2 minutes, preferably about 1 second to 1 minute.

### EXAMPLE

Examples of the invention are given below by way of illustration and not by way of limitation. All parts are by weight.

### Example 1

A coating solution was prepared by mixing 100 parts of a silicone compound of the general formula:

(CH₃)₃SiO(R^{e}CH₃SiO)₆Si(CH₃)₃

wherein R^{e} is 3,4-epoxycyclohexylethyl with 2 parts of (C₁₂H₂₅C₆H₄)₂I⁺·SbF₆⁻. This coating solution was applied to a 0.1-mm polycarbonate sheet (100 × 100 × 0.1 mm) and a 3-mm polycarbonate sheet (100 × 100 × 3.0 mm), using bar coater No. 14. Immediately thereafter, the coatings were exposed to UV radiation in a dose of 200 mJ/cm² for curing.

After the curing, the offsets (upward or downward distances) of the four corners of the 0.1-mm PC sheet relative to its center were measured. An average of the offsets was calculated to judge whether the coat shrunk or expanded. The offset is expressed "+" when the coat shrinks from the setting with the coated surface faced upward so that the sheet becomes concave. The offset is expressed "-" when the coat expands from the setting with the coated surface faced downward so that the sheet becomes concave. The result was -16 mm.

On the 3-mm PC sheet, a Taber abrasion test was carried out (abrasion wheel: CS-10F, weight: 500 g, 100 cycles). Haze was measured before and after the test for determining hardness. A difference in percent haze before and after the test, ΔHaze, was 14%. The results are shown in Table 1.

It is noted that haze was measured by means of Haze Meter NDH2000 by Nippon Denshoku Kogyo Co., Ltd.

### Example 2

The procedure of Example 1 was repeated except that (CH₃)₃SiO(R^{e}CH₃SiO)₈Si(CH₃)₃ was used instead of (CH)₃SiO(R^{e}CH₃SiO)₆Si(CH₃)₃. The results are shown in Table 1.

### Example 3

The procedure of Example 1 was repeated except that (R^{e}CH₃SiO)₄ was used instead of (CH₃)₃SiO(R^{e}CH₃SiO)₆Si(CH₃)₃. The results are shown in Table 1.

### Example 4

The procedure of Example 1 was repeated except that R^{e}(CH₃)₂SiO(R^{e}CH₃SiO)₅(R^{m}CH₃SiO)Si(CH₃)₂R^{e} wherein R^{m} is methacryloxypropyl was used instead of (CH₃)₃SiO(R^{e}CH₃SiO)₆Si(CH₃)₃. The results are shown in Table 1.

### Example 5

The procedure of Example 1 was repeated except that (CH₃)₃SiO(R^{e}CH₃SiO)₄Si(CH₃)₃ was used instead of (CH₃)₃SiO(R^{e}CH₃SiO)₆Si(CH₃)₃. The results are shown in Table 1.

### Example 6

The procedure of Example 1 was repeated except that [R^{e}(CH₃)₂SiO]₃CH₃Si was used instead of (CH₃)₃SiO(R^{e}CH₃SiO)₆Si(CH₃)₃. The results are shown in Table 1.

### Example 7

The procedure of Example 1 was repeated except that [R^{e}(CH₃)₂SiO]₄Si was used instead of (CH₃)₃SiO(R^{e}CH₃SiO)₆Si(CH₃)₃. The results are shown in Table 1.

### Example 8

The procedure of Example 1 was repeated except that a hydrolytic condensate (weight average molecular weight 2,037) between 60 mol% β-(3',4'-epoxycyclohexyl)ethyltrimethoxysilane and 40 mol% dimethyldimethoxysilane was used instead of (CH₃)₃SiO(R^{e}CH₃SiO)₆Si(CH₃)₃. The results are shown in Table 1.

**Table 1**

| Example | 1 | 2 | 3 | 4 | 5 | 6 | 7 | 8 |
|---|---|---|---|---|---|---|---|---|
| Molecular weight | 1266 | 1634 | 736 | 1672 | 898 | 640 | 824 | 2037 |
| Number of R¹ | 6 | 8 | 4 | 8 | 4 | 3 | 4 | 9 |
| Equivalent of R¹ | 211 | 204 | 184 | 209 | 225 | 213 | 206 | 226 |
| Offset (mm) | -16 | -27 | -28 | -21 | -5 | -7 | -4 | -5 |
| ΔHaze (%) | 14 | 11 | 14 | 18 | 15 | 24 | 19 | 19 |

### Comparative Example 1

The procedure of Example 1 was repeated except that (3',4'-epoxycyclohexyl)methyl 3,4-epoxycyclohexylcarboxylate was used instead of (CH₃)₃SiO(R^{e}CH₃SiO)₆Si(CH₃)₃. The results are shown in Table 2.

### Comparative Example 2

The procedure of Example 1 was repeated except that β'-(3',4'-epoxycyclohexyl)ethyltrimethoxysilane was used instead of (CH₃)₃SiO(R^{e}CH₃SiO)₆Si(CH₃)₃. The results are shown in Table 2.

### Comparative Example 3

The procedure of Example 1 was repeated except that a hydrolytic condensate (weight average molecular weight 2,700) of β-(3',4'-epoxycyclohexyl)ethyltrimethoxysilane was used instead of (CH₃)₃SiO(R^{e}CH₃SiO)₆Si(CH₃)₃. The results are shown in Table 2.

### Comparative Example 4

The procedure of Example 1 was repeated except that R^{e}(CH₃)₂SiOSi(CH₃)₂R^{e} was used instead of (CH₃)₃SiO(R^{e}CH₃SiO)₆Si(CH₃)₃. The results are shown in Table 2.

### Comparative Example 5

The procedure of Example 1 was repeated except that R^{e}(CH₃)₂SiO[(CH₃)₂SiO]₂₀Si(CH₃)₂R^{e} was used instead of (CH₃)₃SiO(R^{e}CH₃SiO)₆Si(CH₃)₃. The results are shown in Table 2.

### Comparative Example 6

The procedure of Example 1 was repeated except that R^{e}(CH)₂SiO[(CH₃)₂SiO]₅₀Si(CH₃)₂R^{e} was used instead of (CH₃)₃SiO(R^{e}CH₃SiO)₆Si(CH₃)₃. The results are shown in Table 2.

**Table 2**

| Comparative Example | 1 | 2 | 3 | 4 | 5 | 6 |
|---|---|---|---|---|---|---|
| Molecular weight | 252 | 246 | 2700 | 382 | 1862 | 4082 |
| Number of R¹ | 2 | 1 | 15 | 2 | 2 | 2 |
| Equivalent of R¹ | 126 | 246 | 180 | 191 | 931 | 2041 |
| Offset (mm) | 0 | cylinder cylinder | 10 | 3 | 0 | 0 |
| ΔHaze (%) | 50 | peeled | 30 | 28 | peeled | peeled |

### Reference Example 1

A coating solution was prepared by mixing 50 parts of trimethylolpropane triacrylate and 50 parts of 1.6-hexanediol diacrylate with 5 parts of 2-hydroxy-2-methyl-l-phenyl-propan-1-one. This coating solution was applied to a 0.1-mm polycarbonate sheet (100 × 100 × 0.1 mm), using bar coater No. 14. Immediately thereafter, the coating was exposed to UV radiation for curing, yielding a cure shrinkage of 14 mm.

Further on the coated sheet, the coating solution used in Example 1 was applied as in Example 1. A coat free of curling was obtained.

### Reference Example 2

On the coat which was curled as a result of cure shrinkage in Reference Example 1, the coating solution used in Comparative Example 4 was applied as in Example 1. No improvement in curling was achieved, with the cure shrinkage of 14 mm kept unchanged.

It is thus evident that coating compositions comprising a silicone compound having at least three epoxycyclohexyl-bearing organic groups each directly attached to a silicon atom in a molecule, but free of alkoxy groups, and having a molecular weight of 500 to 2,100 and an epoxycyclohexyl-bearing organic group equivalent (as expressed by the weight per mole of epoxycyclohexyl-bearing organic groups) of 180 to 230, and a photoacid generator which is dissolvable in component (A) cure into coats which experience substantial expansion during the curing process. Reference Example 1 proves that when the curled film is further treated, the curl is mitigated.

No expansion was observed in Comparative Example 1 using a non-silicone resin, Comparative Example 3 using a silicone compound having a molecular weight of more than 2,100, and Comparative Example 4 using a silicone compound having two R¹ in a molecule and having a molecular weight of less than 500. Substantial shrinkage was observed in Comparative Example 2 using a silicone compound having alkoxy groups. The coats of Comparative Examples 5 and 6 using silicone compounds having a high molecular weight and a high R¹ equivalent, commonly used in release paper and similar applications, were soft as demonstrated by the Taber abrasion test where the coats were lost.

It is thus confirmed that the hard protective coat-forming photo-curable coating composition of the first embodiment of the invention forms a coat which is expandable upon curing, free of curling, and resistant to flaw in a Taber abrasion test.

### Example 9

A coating solution was prepared by mixing 30 parts of a silicone compound of the general formula:

(CH₃)₃SiO(R^{e}CH₃SiO)₈Si(CH₃)₃

wherein R^{e} is 3,4-epoxycyclohexylethyl with 100 parts of MEK-dispersed colloidal silica sol MEK-ST (solids 30 wt%, by Nissan Chemical Co., Ltd.) and 1.2 parts of (C₁₂H₂₅C₆H₄)₂I⁺·SbF₆⁻. This coating solution was applied to a 0.1-mm polycarbonate sheet (100 × 100 × 0.1 mm) and a 3-mm polycarbonate sheet (100 × 100 × 3.0 mm), using bar coater No. 20. Immediately thereafter, the coatings were exposed to UV radiation in a dose of 200 mJ/cm² for curing.

After the curing, the offsets (upward or downward distances) of the four corners of the 0.1-mm PC sheet relative to its center were measured. An average of the offsets was calculated to judge whether the coat shrunk or expanded. The offset is expressed "+" when the coat shrinks from the setting with the coated surface faced upward so that the sheet becomes concave. The offset is expressed "-" when the coat expands from the setting with the coated surface faced downward so that the sheet becomes concave. The result was 0 mm.

On the 3-mm PC sheet, a Taber abrasion test was carried out (abrasion wheel: CS-10F, weight: 500 g, 500 cycles). Haze was measured before and after the test for determining hardness. A difference in percent haze before and after the test, ΔHaze, was 13%. The results are shown in Table 3.

It is noted that haze was measured by means of Haze Meter NDH2000 by Nippon Denshoku Kogyo Co., Ltd.

### Example 10

The procedure of Example 9 was repeated except that (R^{e}CH₃SiO)₄ was used instead of (CH₃)₃SiO(R^{e}CH₃SiO)₈Si(CH₃)₃. The results are shown in Table 3.

### Example 11

The procedure of Example 9 was repeated except that 150 parts of MEK-dispersed hollow colloidal silica sol OSCAL (solids 20 wt%, by Catalysts & Chemicals Ind. Co., Ltd.) was used instead of 100 parts of the MEK-dispersed colloidal silica sol MEK-ST (solids 30 wt%, by Nissan Chemical Co., Ltd.). The results are shown in Table 3.

### Example 12

The procedure of Example 9 was repeated except that 150 parts of methanol-dispersed compound titania sol Optolake (solids 20 wt%, by Catalysts & Chemicals Ind. Co., Ltd.), whose solvent had been replaced by MEK, was used instead of 100 parts of the MEK-dispersed colloidal silica sol MEK-ST (solids 30 wt%, by Nissan Chemical Co., Ltd.). The results are shown in Table 3.

**Table 3**

| Example | 9 | 10 | 11 | 12 |
|---|---|---|---|---|
| Molecular weight | 1634 | 736 | 1634 | 1634 |
| Number of R¹ | 8 | 4 | 8 | 8 |
| Equivalent of R¹ | 204 | 184 | 204 | 204 |
| Offset (mm) | 0 | 0 | 0 | 0 |
| ΔHaze (%) | 19 | 13 | 21 | 24 |

### Comparative Example 7

The procedure of Example 9 was repeated except that (3',4'-epoxycyclohexyl)methyl 3,4-epoxycyclohexylcarboxylate was used instead of (CH₃)₃SiO(R^{e}CH₃SiO)₈Si(CH₃)₃. The offset was 10 mm and ΔHaze was >50, with the results shown in Table 4.

### Comparative Example 8

The procedure of Example 9 was repeated except that β-(3',4'-epoxycyclohexyl)ethyltrimethoxysilane was used instead of (CH₃)₃SiO(R^{e}CH₃SiO)₈Si(CH₃)₃. Shrinkage into a cylinder occurred and ΔHaze was >50, with the results shown in Table 4.

### Comparative Example 9

The procedure of Example 9 was repeated except that R^{e}(CH₃)₂SiOSi(CH₃)₂R^{e} was used instead of (CH₃)₃SiO(R^{e}CH₃SiO)₈Si(CH₃)₃. The shrinkage was 12 mm and ΔHaze was >50, with the results shown in Table 4.

### Comparative Example 10

The procedure of Example 9 was repeated except that R^{e}(CH₃)₂SiO[(CH₃)₂SiO]₂₀Si(CH₃)₂R^{e} was used instead of (CH₃)₃SiO(R^{e}CH₃SiO)₈Si(CH₃)₃. The shrinkage was 13 mm and the coat was lost in the Taber abrasion test, with the results shown in Table 4.

### Comparative Example 11

The procedure of Example 9 was repeated except that R^{e}(CH₃)₂SiO[(CH₃)₂SiO]₅₀(CH₃)₂R^{e} was used instead of (CH₃)₃SiO(R^{e}CH₃SiO)₈Si(CH₃)₃. The shrinkage was 11 mm and the coat was lost in the Taber abrasion test, with the results shown in Table 4.

**Table 4**

| Comparative Example | 7 | 8 | 9 | 10 | 11 |
|---|---|---|---|---|---|
| Molecular weight | 252 | 246 | 382 | 1862 | 4082 |
| Number of R¹ | 2 | 1 | 2 | 2 | 2 |
| Equivalent of R¹ | 126 | 246 | 191 | 931 | 2041 |
| Offset (mm) | 10 | shrunk into cylinder | 12 | 13 | 11 |
| ΔHaze (%) | >50 | peeled | >50 | peeled | peeled |

It is thus evident that coating compositions comprising a silicone compound comprising -R¹RSiO_{2/2}- units, having at least three R¹ in a molecule, but free of alkoxy groups, and having a molecular weight of 500 to 2,100 and an R¹ equivalent of 180 to 220, a photoacid generator and inorganic oxide particles cure into high hardness coats which experience no curling.

In Comparative Example 7 using a non-silicone resin and Comparative Example 9 using a silicone compound having two R¹ in a molecule and having a molecular weight of less than 500, the coats shrunk upon curing and had an insufficient hardness. Substantial shrinkage was observed in Comparative Example 8 using a silicone compound having alkoxy groups. The coats of Comparative Examples 10 and 11 using silicone compounds having a high molecular weight and a high R¹ equivalent, commonly used in release paper and similar applications, were soft as demonstrated by the Taber abrasion test where the coats were lost.

It is thus confirmed that the hard protective coat-forming photo-curable coating composition of the second embodiment of the invention forms a high hardness coat which experiences no curling.

### Synthesis Example 1

### Synthesis of radical cure acrylic resin

A mixture of 56 parts of Snowtex O (solids 20 wt%, Nissan Chemical Co., Ltd.), 7.8 parts of γ-methacryloxypropyltrimethoxysilane, and 155 parts of isopropyl alcohol was heated under reflux for one hour. After cooling, 100 parts of the solution was combined with 31.5 parts of trimethylolpropane triacrylate and 10.5 parts of hexanediol diacrylate, and neutralized with sodium hydroxide. The solvent was distilled off in vacuum, leaving a clear solution. Finally, 0.3 part of Darocure 1173 (Ciba) was added to the solution, yielding a radical cure acrylic resin solution, designated AC.

### Synthesis Example 2

### Synthesis of condensation cure silicone resin

A mixture of 3891 parts of water and 654 parts of xylene was heated at 80°C, to which a mixture of 160 parts of dimethyldichlorosilane, 153 parts of methyltrichlorosilane and 390 parts of phenyltrichlorosilane was added dropwise over one hour. The solution was washed with water, and the solvent distilled off, yielding a condensation cure silicone resin, designated SI.

### Example 13

A coating solution was prepared by mixing 100 parts of a silicone compound of the general formula:

(CH₃)₃SiO(R^{e}CH₃SiO)₈Si(CH₃)₃

wherein R^{e} is 3,4-epoxycyclohexylethyl with 100 parts of the acrylic resin (AC) obtained in Synthesis Example 1 and 2 parts of (C₁₂H₂₅C₆H₄)₂I⁺·SbF₆⁻. This coating solution was applied to a 0.1-mm polycarbonate sheet (100 × 100 × 0.1 mm) and a 3-mm polycarbonate sheet (100 × 100 × 3.0 mm), using bar coater No. 20. Immediately thereafter, the coatings were exposed to UV radiation in a dose of 200 mJ/cm² for curing.

After the curing, the offsets (upward or downward distances) of the four corners of the 0.1-mm PC sheet relative to its center were measured. An average of the offsets was calculated to judge whether the coat was shrunk or expanded. The offset is expressed "+" when the coat shrinks from the setting with the coated surface faced upward so that the sheet becomes concave. The offset is expressed "-" when the coat expands from the setting with the coated surface faced downward so that the sheet becomes concave. The result was 0 mm.

On the 3-mm PC sheet, a Taber abrasion test was carried out (abrasion wheel: CS-10F, weight: 500 g, 100 cycles). Haze was measured before and after the test for determining hardness. A difference in percent haze before and after the test, ΔHaze, was 15%. The results are shown in Table 5.

It is noted that haze was measured by means of Haze Meter NDH2000 by Nippon Denshoku Kogyo Co., Ltd.

### Example 14

The procedure of Example 13 was repeated except that (R^{e}CH₃SiO)₄ was used instead of (CH₃)₃SiO(R^{e}CH₃SiO)₈Si(CH₃)₃. The results are shown in Table 5.

### Example 15

The procedure of Example 13 was repeated except that the silicone resin (SI) obtained in Synthesis Example 2 was used instead of the acrylic resin (AC). The results are shown in Table 5.

**Table 5**

| Example | 13 | 14 | 15 |
|---|---|---|---|
| Molecular weight | 1634 | 736 | 1634 |
| Number of R¹ | 8 | 4 | 8 |
| Equivalent of R¹ | 204 | 184 | 204 |
| Offset (mm) | 0 | -1 | 0 |
| ΔHaze (%) | 10 | 13 | 19 |

### Comparative Example 12

The procedure of Example 13 was repeated except that (3',4'-epoxycyclohexyl)methyl 3,4-epoxycyclohexylcarboxylate was used instead of (CH₃)₃SiO(R^{e}CH₃SiO)₈Si(CH₃)₃. The results shown in Table 6.

### Comparative Example 13

The procedure of Example 13 was repeated except that β-(3',4'-epoxycyclohexyl)ethyltrimethoxysilane was used instead of (CH₃)₃SiO(R^{e}CH₃SiO)₈Si(CH₃)₃. The results are shown in Table 6.

### Comparative Example 14

The procedure of Example 13 was repeated except that R^{e}(CH₃)₂SiOSi(CH₃)₂R^{e} was used instead of (CH₃)₃SiO(R^{e}CH₃SiO)₈Si(CH₃)₃. The results are shown in Table 6.

### Comparative Example 15

The procedure of Example 13 was repeated except that R^{e}(CH₃)₂SiO[(CH₃)₂SiO]₂₀Si(CH₃)₂R^{e} was used instead of (CH₃)₃SiO(R^{e}CH₃SiO)₈Si(CH₃)₃. The results are shown in Table 6.

### Comparative Example 16

The procedure of Example 13 was repeated except that R^{a}(CH₃)₂SiO[(CH₃)₂SiO]₅₀Si(CH₃)₂R^{a} was used instead of (CH₃)₃SiO(R^{e}CH₃SiO)₈Si(CH₃)₃. The results are shown in Table 6.

**Table 6**

| Comparative Example | 12 | 13 | 14 | 15 | 16 |
|---|---|---|---|---|---|
| Molecular weight | 252 | 246 | 382 | 1862 | 4082 |
| Number of R¹ | 2 | 1 | 2 | 2 | 2 |
| Equivalent of R¹ | 126 | 246 | 191 | 931 | 2041 |
| Offset (mm) | 15 | shrunk into cylinder | 20 | 14 | 16 |
| ΔHaze (%) | 50 | peeled | 28 | peeled | peeled |

It is thus evident that coating compositions comprising a silicone compound having at least three R¹ in a molecule, but free of alkoxy groups, and having a molecular weight of 500 to 2,100 and a R¹ equivalent of 180 to 220, a photoacid generator and a curable resin which is shrinkable upon curing cure into hard coats which experience no curling after curing and is resistant to flaw in a Taber abrasion test.

It is thus confirmed that the hard protective coat-forming photo-curable coating composition of the third embodiment of the invention forms a hard coat which experiences no curling and is resistant to flaw in a Taber abrasion test.

Japanese Patent Application Nos. 2002-098694, 2002-098705 and 2002-098734 are incorporated herein by reference.

Although some preferred embodiments have been described, many modifications and variations may be made thereto in light of the above teachings. It is therefore to be understood that the invention may be practiced otherwise than as specifically described without departing from the scope of the appended claims.

## Claims

1. A photo-curable coating composition for forming a hard protective coat, comprising
(A) 100 parts by weight of a silicone compound having at least three epoxycyclohexyl-bearing organic groups each directly attached to a silicon atom in a molecule, but free of alkoxy groups, and having a molecular weight of 500 to 2,100 and an epoxycyclohexyl-bearing organic group equivalent of 180 to 230, and
(B) 0.1 to 5 parts by weight of a photoacid generator which is dissolvable in component (A).

2. The coating composition of claim 1 wherein component (A) is a silicone compound comprising units of the general formula (1):
-R¹RSiO_{2/2}- (1)
wherein R is hydrogen or a monovalent hydrocarbon group and R¹ is an epoxycyclohexyl-bearing organic group, containing at least three R¹ in a molecule, but free of alkoxy groups, and having a molecular weight of 500 to 2,100 and an R¹ equivalent of 180 to 220.

3. The coating composition of claim 2 wherein component (A) is a silicone compound having the general formula (2): 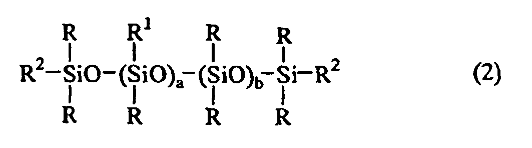
wherein R and R¹ are as defined above, R² is R or R¹, and a is an integer of 1 to 10, with the proviso that R² at each end is R¹ when a = 1, and at least one of R² is R¹ when a = 2, b is an integer of 0 to 8, the sum of a+b is 2 to 10, and each R, R¹ and R² may be the same or different.

4. The coating composition of claim 3 wherein component (A) is a silicone compound having the general formula (3):
(CH₃)₃SiO(R¹CH₃SiO)ₘSi(CH₃)₃ (3)
wherein R¹ is as defined above and m is an integer of 3 to 10.

5. The coating composition of claim 2 wherein component (A) is a silicone compound having the general formula (4): 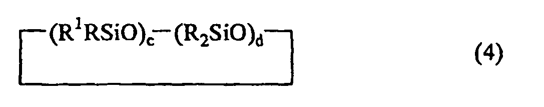
wherein R and R¹ are as defined above, c is an integer of 3 to 5, d is an integer of 0 to 3, and the sum of c+d is 3 to 5.

6. The coating composition of claim 5 wherein component (A) is a silicone compound having the general formula (5): 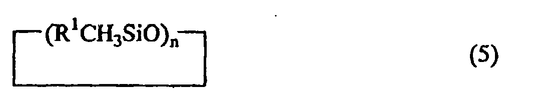
wherein R¹ is as defined above and n is an integer of 3 to 5.

7. The coating composition of any one of claims 1 to 6 wherein component (B) is a photoacid generator having the general formula (6):
R⁴₂I⁺X⁻ (6)
wherein R⁴ is -C₆H₄-R⁵, R⁵ is an alkyl having at least 6 carbon atoms, and X is SbF₆⁻, AsF₆⁻, PF₆⁻, BF₄⁻, HSO₄⁻, ClO₄⁻, Cl⁻ or CF₃SO₃⁻.

8. The coating composition of any one of claims 1 to 7 which is expandable upon curing.

9. An article on which a hard protective coat is formed by applying and curing the coating composition of any one of claims 1 to 8.

10. The coating composition of any one of claims 1 to 7, further comprising (C) 30 to 400 parts by weight of inorganic oxide particles having an average particle size of 1 to 500 nm.

11. The coating composition of claim 10 wherein component (C) is particles of at least one inorganic oxide selected from the group consisting of silica, aluminum oxide, zirconium oxide, and titanium oxide.

12. The coating composition of claim 10 wherein component (C) is inorganic oxide particles having a cavity therein.

13. The coating composition of claim 10 wherein component (C) is inorganic oxide particles dispersed in an alcohol or ketone.

14. The coating composition of claim 13 wherein component (C) is inorganic oxide particles dispersed in methyl ethyl ketone.

15. An article on which a hard protective coat is formed by applying and curing the coating composition of any one of claims 10 to 14.

16. The coating composition of any one of claims 1 to 7, further comprising (D) 1 to 400 parts by weight of a curable resin which is shrinkable upon curing.

17. The coating composition of claim 16 wherein component (D) is a radical cure resin.

18. The coating composition of claim 17 wherein component (D) is an acrylic resin.

19. The coating composition of claim 16 wherein component (D) is a condensation cure resin.

20. The coating composition of claim 19 wherein component (D) is a silicone resin.

21. An article on which a hard protective coat is formed by applying and curing the coating composition of any one of claims 16 to 20.

## Revendications

1. Composition de revêtement photodurcissable pour former une couche protectrice dure comprenant
(A) 100 parties en poids d'un composé de silicone ayant au moins trois groupes organiques porteurs d'époxycyclohexyle, chacun directement attaché à un atome de silicium dans une molécule, mais sans groupe alcoxy et ayant un poids moléculaire de 500 à 2100 et un équivalent en groupe organique porteur d'époxycyclohexyle de 180 à 230, et
(B) 0,1 à 5 parties en poids d'un générateur de photoacides qui peut être dissous dans le composant (A).

2. composition de revêtement de la revendication 1 où le composant (A) est un composé de silicium comprenant des unités de la formule générale (1):
-R¹RSiO_{2/2}- (1)
où R est hydrogène ou un groupe hydrocarbure monovalent et R¹ est un groupe organique porteur d'époxycyclohexyle, contenant au moins trois R¹dans une molécule, mais sans groupes alcoxy, et ayant un poids moléculaire de 500 à 2100 et un équivalent R¹ de 180 à 220.

3. Composition de revêtement de la revendication 2 où le composant (A) est un composé de silicone ayant la formule générale (2): 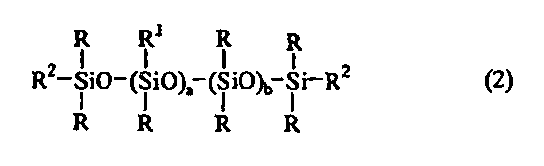
où R et R¹ sont tels que définis ci-dessus, R² est R ou R¹. et a est un entier de 1 à 10, à condition que R²à chaque extrémité soit R¹ quand a = 1, et au moins l'un de R² soit R¹ quand a = 2, b est un entier de 0 à 8, la somme de a+b est 2 à 10, et chaque R, R¹ et R² peut être identique ou différent.

4. Composition de revêtement de la revendication 3 où le composant (A) est un composé de silicone ayant la formule générale (3):
(CH₃)₃SiO(R¹CH₃SiO)ₘSi(CH₃)₃ (3)
où R¹ est tel que défini ci-dessus et m est un entier de 3 à 10.

5. Composition de revêtement de la revendication 2 où le composant (A) est un composé de silicone ayant la formule générale (4): 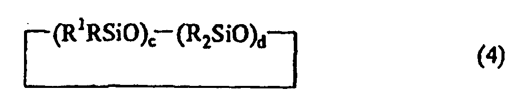
où R et R¹ sont tels que définis ci-dessus, c est un entier de 3 à 5, d est un entier de 0 à 3, et la somme de c+d est 3 à 5.

6. Composition de revêtement de la revendication 5 où le composant (A) est un composé de silicone ayant la formule générale (5): 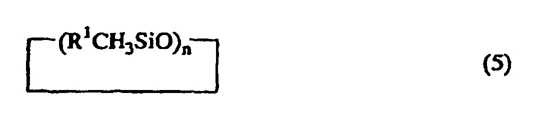
où R¹ est tel que défini ci-dessus et n est un entier de 3 à 5.

7. Composition de revêtement de l'une quelconque des revendications 1 à 6 où le composant (B) est un générateur de photoacides ayant la formule générale (6):
R⁴₂I⁺X⁻ (6)
où R⁴ est -C₆H₄-R⁵, R⁵ est un alkyle ayant au moins 6 atomes de carbone, et X est SbF₆⁻, AsF₆⁻, PF₆⁻, BF₉⁻, HSO₄⁻, ClO₄⁻, Cl⁻ ou CF₃SO₃⁻.

8. Composition de revêtement de l'une quelconque des revendications 1 à 7 qui est dilatable au durcissement.

9. Article sur lequel est formée une couche protectrice dure par application et durcissement de la composition de revêtement de l'une quelconque des revendications 1 à 8.

10. Composition de revêtement de l'une quelconque des revendications 1 à 7, comprenant de plus (C) 30 à 400 parties en poids de particules d'un oxyde inorganique ayant une dimension moyenne de particules de 1 à 500 nm.

11. Composition de revêtement de la revendication 10 où le composant (C) est formé de particules d'au moins un oxyde inorganique sélectionné dans le groupe consistant en silice, oxyde d'aluminium, oxyde de zirconium, et oxyde de titane.

12. Composition de revêtement de la revendication 10 où le composant (C) est formé de particules d'oxyde inorganique ayant une cavité.

13. Composition de revêtement de la revendication 10, où le composant (C) est formé de particules d'oxyde inorganique dispersées dans un alcool ou une cétone.

14. Composition de revêtement de la revendication 13 où le composant (C) est formé de particules d'oxyde inorganique dispersées dans la méthyl éthyl cétone.

15. Article sur lequel est formée une couche protectrice dure par application et du rcissement de la composition de revêtement de l'une quelconque des revendications 10 à 14.

16. Composition de revêtement de l'une quelconque des revendications 1 à 7 comprenant de plus (D) 1 à 400 parties en poids de résine durcissable qui est rétractable au durcissement.

17. Composition de revêtement de la revendication 16 où le composant (D) est une résine à durcissement par les radicaux.

18. Composition de revêtement de la revendication 17 où le composant (D) est une résine acrylique.

19. Composition de revêtement de la revendication 16 où le composant (D) est une résine durcissant par condensation.

20. Composition de revêtement de la revendication 19 où le composant (D) est une résine de silicone.

21. Article sur lequel une couche protectrice dure est formée par application et durcissement de la composition de revêtement de l'une quelconque des revendications 16 à 20.

## Patentansprüche

1. Lichthärtbare Beschichtungszusammensetzung zur Ausbildung eines harten Schutzüberzugs, umfassend:
(A) 100 Gewichtsteile einer Siliconverbindung, die zumindest drei Epoxycyclohexyl-hältige organische Gruppen, die jeweils direkt an ein Siliciumatom im Molekül gebunden sind, aufweist, aber frei von Alkoxygruppen ist, ein Molekulargewicht von 500 bis 2.100 aufweist und ein Äquivalent an Epoxycyclohexyl-hältigen organischen Gruppen von 180 bis 230 aufweist, und
(B) 0,1 bis 5 Gewichtsteile eines Photosäurebildners, der in Komponente (A) löslich ist.

2. Beschichtungszusammensetzung nach Anspruch 1, worin Komponente (A) eine Siliconverbindung ist, die Einheiten der allgemeinen Formel (1):
-R¹RSiO_{2/2}- (1)
worin R Wasserstoff oder eine einwertige Kohlenwasserstoffgruppe ist und R¹ eine Epoxycyclohexyl-hältige organische Gruppe ist, umfasst, zumindest drei R¹ pro Molekül enthält, aber frei von Alkoxygruppen ist, ein Molekulargewicht von 500 bis 2.100 aufweist und ein R¹-Äquivalent von 180 bis 220 aufweist.

3. Beschichtungszusammensetzung nach Anspruch 2, worin Komponente (A) eine Siliconverbindung der allgemeinen Formel (2) ist: 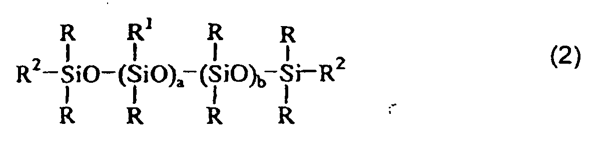
worin R und R¹ wie oben definiert sind, R² = R oder R¹ ist und a eine ganze Zahl von 1 bis 10 ist, mit der Maßgabe, dass R² an jedem Ende R¹ ist, wenn a = 1 ist, und zumindest eines der R² = R¹ ist, wenn a = 2 ist, b eine ganze Zahl von 0 bis 8 ist, die Summe von a+b = 2 bis 10 ist, und die R, R¹ und R² jeweils gleich oder unterschiedlich sein können.

4. Beschichtungszusammensetzung nach Anspruch 3, worin Komponente (A) eine Siliconverbindung der allgemeinen Formel (3) ist:
(CH₃)₃SiO(R¹CH₃SiO)ₘSi(CH₃)₃ (3)
worin R¹ wie oben definiert ist und m eine ganze Zahl von 3 bis 10 ist.

5. Beschichtungszusammensetzung nach Anspruch 2, worin Komponente (A) eine Siliconverbindung der allgemeinen Formel (4) ist: 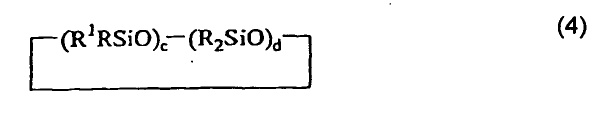
worin R und R¹ wie oben definiert sind, c eine ganze Zahl von 3 bis 5 ist, d eine ganze Zahl von 0 bis 3 ist und die Summe von c+d = 3 bis 5 ist.

6. Beschichtungszusammensetzung nach Anspruch 5, worin Komponente (A) eine Siliconverbindung der allgemeinen Formel (5) ist: 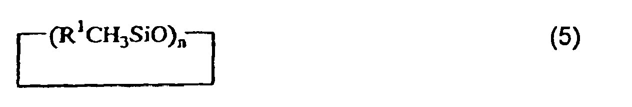
worin R¹ wie oben definiert ist und n eine ganze Zahl von 3 bis 5 ist.

7. Beschichtungszusammensetzung nach einem der Ansprüche 1 bis 6, worin Komponente (B) ein Photosäurebildner der allgemeinen Formel (6) ist:
R⁴₂I⁺X⁻ (6)
worin R⁴ -C₆H₄-R⁵ ist, R⁵ ein Alkyl mit zumindest 6 Kohlenstoffatomen ist und X SbF₆⁻, AsF₆⁻, PF₆⁻, BF₄⁻, HSO₄⁻, ClO₄⁻, Cl⁻ oder CF₃SO₃⁻ ist.

8. Beschichtungszusammensetzung nach einem der Ansprüche 1 bis 7, die beim Härten schäumbar ist.

9. Gegenstand, auf dem ein harter Schutzüberzug durch Aufbringen und Härten einer Beschichtungszusammensetzung nach einem der Ansprüche 1 bis 8 ausgebildet ist.

10. Beschichtungszusammensetzung nach einem der Ansprüche 1 bis 7, die weiters (C) 30 bis 400 Gewichtsteile anorganischer Oxidteilchen mit einer mittleren Teilchengröße von 1 bis 500 nm umfasst.

11. Beschichtungszusammensetzung nach Anspruch 10, worin Komponente (C) aus Teilchen zumindest eines anorganischen Oxids besteht, das aus der aus Siliciumoxid, Aluminiumoxid, Zirkoniumoxid und Titanoxid bestehenden Gruppe ausgewählt ist.

12. Beschichtungszusammensetzung nach Anspruch 10, worin Komponente (C) anorganische Oxidteilchen mit einem Hohlraum darin sind.

13. Beschichtungszusammensetzung nach Anspruch 10, worin Komponente (C) in einem Alkohol oder Keton dispergierte anorganische Oxidteilchen sind.

14. Beschichtungszusammensetzung nach Anspruch 13, worin Komponente (C) in Methylethylketon dispergierte anorganische Oxidteilchen sind.

15. Gegenstand, auf dem ein harter Schutzüberzug durch Aufbringen und Härten einer Beschichtungszusammensetzung nach einem der Ansprüche 10 bis 14 ausgebildet ist.

16. Beschichtungszusammensetzung nach einem der Ansprüche 1 bis 7, die weiters (D) 1 bis 400 Gewichtsteile eines härtbaren Harzes umfasst, das beim Härten schrumpfbar ist.

17. Beschichtungszusammensetzung nach Anspruch 16, worin Komponente (D) ein radikalisch härtbares Harz ist.

18. Beschichtungszusammensetzung nach Anspruch 17, worin Komponente (D) ein Acrylharz ist.

19. Beschichtüngszusammehsetzung nach Anspruch 16, worin Komponente (D) ein kondensationshärtbares Harz ist.

20. Beschichtungszusammensetzung nach Anspruch 19, worin Komponente (D) ein Siliconharz ist.

21. Gegenstand, auf dem ein harter Schutzüberzug durch Aufbringen und Härten einer Beschichtungszusammensetzung nach einem der Ansprüche 16 bis 20 ausgebildet ist.
